# EUROPEAN PATENT SPECIFICATION

(11) **EP 2 122 830 B1**
(45) Date of publication and mention of the grant of the patent: **11.04.2018**
(21) Application number: 08716768.0
(22) Date of filing: 07.02.2008
(51) Int. Cl.: H03K 21/08, H03L 7/18, G06F 1/06, H03K 21/40, H03K 23/68, H03L 7/099

(54) **A CLOCK CIRCUIT**
TAKTSCHALTUNG
CIRCUIT D'HORLOGE

(30) Priority: 09.02.2007 GB 0702590
(43) Date of publication of application: 25.11.2009
(73) Proprietor: TEXAS INSTRUMENTS LIMITED, Northampton Business Park, Northampton NN4 7YL (GB)
(72) Inventor: LYTOLLIS, Shaun, Silverstone Northamptonshire NN12 8DN (GB)
(74) Representative: Zeller, Andreas
(86) International application number: PCT/EP2008/051492
(87) International publication number: WO 2008/095974

(56) References cited:
- US-A1- 2003 198 311
- US-A1- 2005 168 290
- US-A1- 2005 242 848

## Description

This invention relates to a clock circuit.

When data is transmitted between a transmitter circuit and a receiver circuit, it is common for the receiver unit to use the transitions between 0s and 1s in order to stay synchronised with the transmitter unit, rather than using a separate clock signal. This is known as "clock recovery". However, a problem with clock recovery is that, when a long run of 0s or 1s is transmitted, as there are no transitions the receiver circuit can get out of synchronisation with the data signal.

In order to avoid this problem it is common to encode the data signal so that it does not contain long runs with no transitions. There are various known encodings, one of which is 64B/66B encoding. In 64B/66B encoding a two-bit "preamble" 01 or 10 is added to each 64 bits of data. (The choice of 01 or 10 can be used to give additional information about the data being sent.) Thus every 66 bits of data contain at least one transition, and so the receiver is able to stay in synchronisation with the data signal. The original signal is then recovered by simply removing the two-bit preamble from each 66 bits of data in the data signal.

In order to capture data from the 66-bit data signal, the receiver circuit requires a 66-bit clock. In practice, a double-rate clock, in other words a 33-bit clock, is often used. A common method of producing a 33-bit clock is to use a 4-bit clock. (Such clocks are commonly available in electronic circuits where they are also used for other purposes.) The 4-bit clock signal is divided by 8, to give a 32-bit clock signal. The 4-bit clock is then used to add two bits to every other clock cycle, giving a clock that alternates on each clock cycle between being a 32-bit clock and a 34-bit clock, and is thus on average a 33-bit clock as required. However, the "jitter" of 1 bit between clock cycles is often disadvantageous and can lead to problems when capturing data from the data signal.

United States Patent Application US 2003/198311 describes a fractional-N frequency synthesizer based on a PLL which employs a multi-phase VCO and a multi-phase frequency divider to provide a desired fractional-N divider ratio. The multi-phase frequency divider includes a multi-modulus divider which divides a VCO output waveform with a division ratio that varies in response to a modulus control signal. The divided output is delayed to produce a plurality of outputs, each of which has a respective phase that corresponds with the phase of a respective VCO output. A phase selector provides a selected one of the outputs to the PLL's phase detector in response to a phase control signal such that the multi-phase frequency divider provides a fractional-N division ratio. To reduce fractional spurs, a modulator randomizes the modulus and phase control signals, which serves to randomize and reduce phase mismatch error which might otherwise be present in the frequency synthesizer's output

United States Patent Application US 2005/242848 describes a phase selectable divider circuit including a select circuit receiving a plurality of signals having a common frequency and a different phase. One of the plurality of signals, having a first phase, is selected as a selector circuit output signal, A first value corresponding to the first phase is summed with a second value corresponding to a phase offset from the first phase to generate a sum indicative thereof. That sum is used to select a second one of the signals having a second phase as the next selector circuit output signal. As successive sums are generated, a pulse train is supplied by selector circuit having a desired frequency.

According to the present invention there is provided a clock circuit and a method of generating a clock signal as set out in the appended claims.

The delay circuits may be capture circuits arranged to capture the output of a divider circuit based on one of the input clock signals.

The clock circuit may comprise a respective divider circuit for each input clock signal. The delay circuits may comprise respective delays that take as input the outputs of the delay circuits.

Preferably, the selection circuit selects the next output in the sequence when the selected output changes from the first state to the second state.

The clock circuit may further comprise a selection signal generating circuit arranged to generate a respective selection signal for each output of a delay circuit. Advantageously, the selection circuit further comprises a respective AND gate for each output of a delay circuit, and the inputs of the AND gate are the output of the delay circuit and its respective selection signal. Advantageously, the selection circuit further comprises an OR gate, and the inputs of the OR gate are the outputs of the AND gates.

The selection circuit may comprise a multiplexer. Advantageously, the selection circuit further comprises a counter arranged to select the output of the multiplexer. Advantageously, the counter is arranged to increment when the selected output changes from the first state to the second state.

Examples of the invention will now be described with reference to the accompanying drawings, of which:
Figure 1 is a block diagram a receiver circuit, in which the invention may be used;
Figure 2 shows the feed forward equaliser and the decision feedback equaliser of the receiver circuit of Figure 1;
Figure 3 is a graph showing the post equalised signal amplitude for exemplary bit patterns;
Figure 4 is a diagram of a transmitter, in which the invention may be used;
Figure 5a shows the response of the receiver to a PRBS transmitted eye-pattern;
Figure 5b shows the interleaved output of the ADCs of the receiver;
Figure 6 is a waveform diagram of four 4-bit clock signals;
Figure 7 is a circuit diagram of a 4/5 divider;
Figure 8 is a waveform diagram for the 4/5 divider;
Figure 9a is a circuit diagram of a circuit for generating waveforms as required to provide a 33-bit clock according to the present invention;
Figure 9b is a circuit diagram of an alternative circuit for generating waveforms as required to provide a 33-bit clock according to the present invention;
Figure 10 is a waveform diagram of the waveforms provided by the circuit of Figure 9;
Figure 11a is a circuit diagram of a circuit for selecting the waveforms output by the circuit of Figure 9 to provide the 33-bit clock;
Figure 11b is a circuit diagram of an alternative circuit for selecting the waveforms output by the circuit of Figure 9 to provide the 33-bit clock;
Figure 12 is a waveform diagram of the waveforms as required to provide a 39-bit clock according to the present invention.

A key challenge facing designers of high-bandwidth systems such as data-routers and super-computers is the requirement to transfer large amounts of data between ICs - either on the same circuit board or between boards. This data transmission application is called Serialisation-Deserialisation or "SerDes" for short. The present invention is useful in SerDes circuit and indeed was developed for that application. Nonetheless the invention may be used in other applications.

Analysis of typical backplane channel attenuation (which is around -24dB) and package losses (-1 to -2dB) in the presence of crosstalk predict that an un-equalized transceiver provides inadequate performance and that decision feedback equalization (DFE) is needed to achieve error rates of less than 10-17.

Traditional decision-feedback equalization (DFE) methods for SerDes receivers rely on either modifying, in analogue, the input signal based on the data history ["A 6.25Gb/s Binary Adaptive DFE with First Post-Cursor tap Cancellation for Serial backplane Communications" R Payne et al ISSCC 2005; "A 6.4Gb/s CMOS SerDes Core with feed-forward and Decision Feedback Equalization" M. Sorna et al ISSCC 2005; "A 4.8-6.4Gb/s serial Link for Backplane Applications Using Decision Feedback Equalization" Balan et al IEEE JSSC Nov 2005.] or on having an adaptive analogue slicing level ["Techniques for High-Speed implementation of Non-linear cancellation" S.Kasturia IEEE Journal on selected areas in Communications. June 1991.] (i.e. the signal level at which the circuit decides whether the signal represents a 1 or a 0).

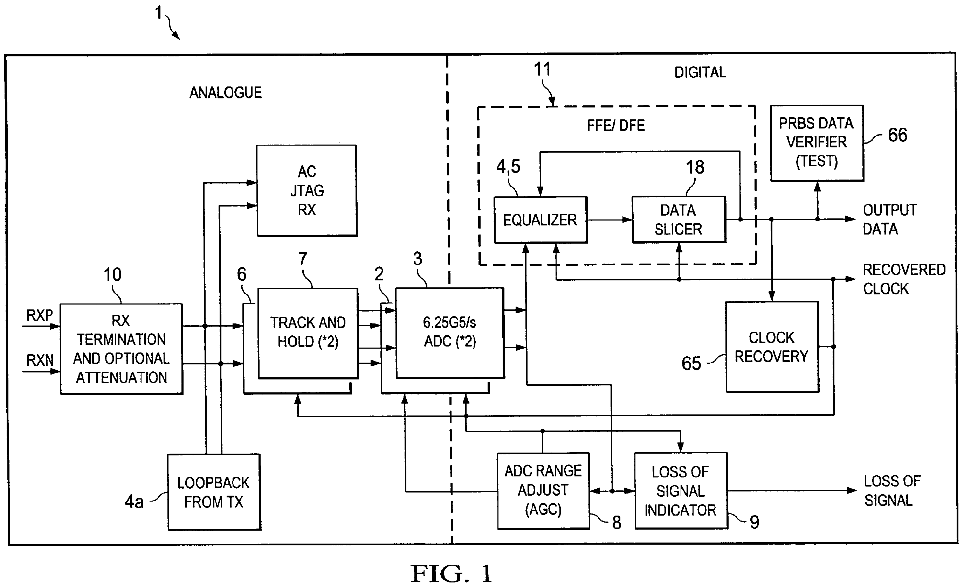

A block diagram of a SerDes receiver circuit 1, which forms part of an integrated circuit, in which the present invention may be used is shown in Figure 1. The invention may nonetheless be used in other applications.

In the receiver circuit 1 of Figure 1 the input data is sampled at the baud-rate, digitized and the equalization and clock & data recovery (CDR) performed using numerical digital processing techniques. This approach results in the superior power/area scaling with process of digital circuitry compared to that of analogue, simplifies production testing, allows straightforward integration of a feed-forward equalizer and provides a flexible design with a configurable number of filter taps in the decision feedback equaliser. The circuit has been implemented in 65nm CMOS, operating at a rate of 12.5Gb/s.

The receiver circuit 1 comprises two baud-rate sampling ADCs (analogue to digital converters) 2 and 3, a digital 2-tap FFE (feed forward equaliser) 4 and digital 5-tap DFE (decision feedback equaliser) 5 to correct channel impairments.

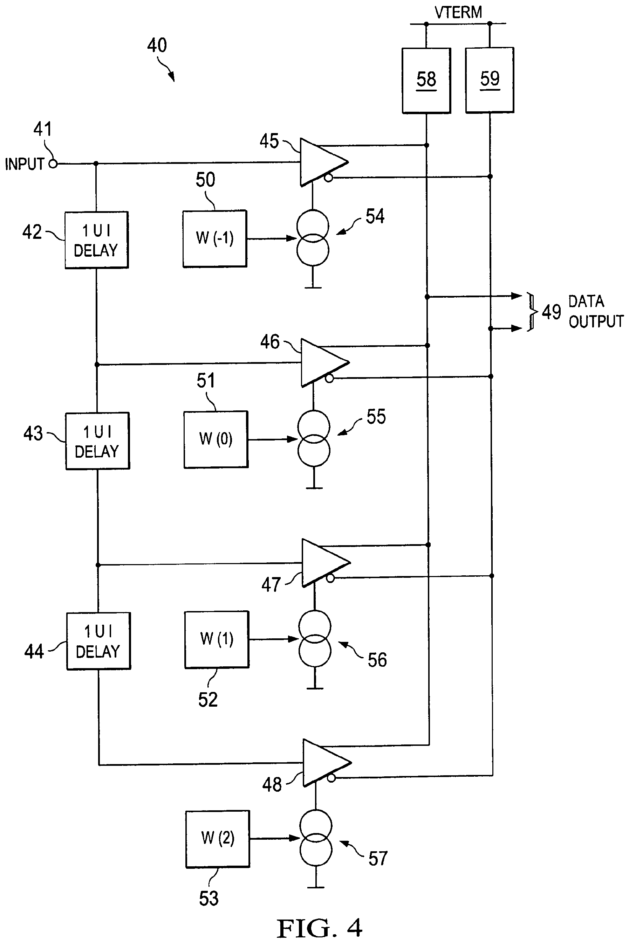

The SerDes section of the integrated circuit, which includes the receiver circuit 1 is also provided with a transmitter 40 (Figure 4), connected to transmit data over a parallel channel to that which the receiver circuit 1 is connected to receive data. The transmitter 40 comprises a 4-tap FIR filter to pre-compensate for channel impairments. In many applications the integrated circuit transmitting data to the receiver circuit 1 uses pre-compensation and in particular a similar transmitter circuit 40, but in other applications the receiver circuit 1 works without pre-compensation being used at the other end

The receiver 1 of Figure 1 is now described in more detail. The received data is digitized at the baud-rate, typically 1.0 to 12.5 Gb/s, using a pair of interleaved track and hold stages (T/H) 6 and 7 and a respective pair of 23 level (4.5 bit) full-flash ADCs 2 and 3 (i.e. they sample and convert alternate bits of the received analogue data waveform). The two track & hold circuits enable interleaving of the half-rate ADCs and reduce signal related aperture timing errors. The two ADCs, each running at 6.25 Gb/s for 12.5 Gb/s incoming data rate provide baud-rate quantization of the received data. The ADC's dynamic range is normalized to the full input amplitude using a 7-bit automatic gain control (AGC) circuit 8. A loss of signal indication is provided by loss of signal unit 9 that detects when the gain control signal provided by the AGC is out-of-range. An optional attenuator is included in the termination block 10, which receives the signals from the transmission channel, to enable reception of large signals whilst minimizing signal overload.

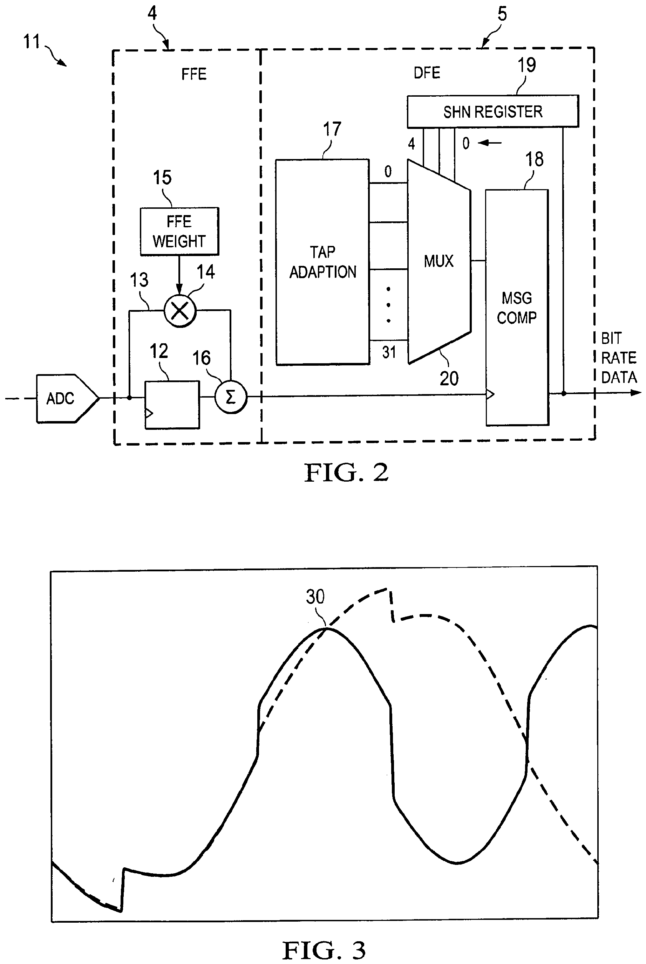

The digital samples output from the ADCs 2 and 3 are interleaved and the resulting stream of samples is fed into a custom digital signal processing (DSP) data-path that performs the numerical feed-forward equalization and decision-feedback equalization. This is shown in Figure 2. This comprises a 1 UI delay register 12 connected to receive the stream of samples from the ADCs 2 and 3. (1 UI is a period of the clock, i.e. the delay between bits.) A tap 13 also feeds the samples from the ADCs to a multiplier 14, each sample being received by the delay latch 12 and the multiplier 14 at the same time. The multiplier 14 multiplies each sample by a constant weight value (held in a programmable register 15), which value is typically 10%. The outputs of the multiplier 14 and the delay register 12 are added together by an adder 16 to provide the output of the FFE 4.

The digital FFE/DFE is implemented using standard 65nm library gates.

An advantage of applying the equalization digitally is that it is straightforward to include feed-forward equalization as a delay-and-add function without any noise-sensitive analogue delay elements. The FFE tap weight is selected before use to compensate for pre-cursor ISI and can be bypassed to reduce latency. Whilst many standards require pre-cursor de-emphasis at the transmitter, inclusion at the receiver allows improved bit error rate (BER) performance with existing legacy transmitters.

The DFE 5 uses an unrolled non-linear cancellation method ["Techniques for High-Speed implementation of Non-linear cancellation" S.Kasturia IEEE Journal on selected areas in Communications. June 1991]. The data output (i.e. the 1s and 0s originally transmitted) is the result of a magnitude comparison between the output of the FFE 4 and a slicer-level dynamically selected from a set stored in a set 17 of pre-programmed registers. The values are determined by a control circuit (not shown in Figure 1) from the waveforms of test patterns sent during a setup phase of operation. The magnitude comparison is performed by a magnitude comparator 18 connected to receive the output of the FFE 4 and the selected slicer-level; it outputs a 1 if the former is higher than the latter and a 0 if it is lower or equal, thereby forming the output of the DFE 5.

The slicer-level is selected from one of 2n possible options depending on the previous n bits of data history. The history of the bits produced by the magnitude comparator 18 is recorded by a shift register 19 which is connected to shift them in. The parallel output of the shift register is connected to the select input of a multiplexer 20 whose data inputs are connected to the outputs of respective ones of the set 17 of registers holding the possible slicer-levels.

Unrolled tap adaption is performed using a least mean square (LMS) method where the optimum slicing level is defined to be the average of the two possible symbol amplitudes (+/-1) when proceeded by identical history bits. (For symmetry the symbols on the channel for the bit values 1 and 0 are given the values +1 and -1).

Although 5-taps of DFE were chosen for this implementation, this parameter is easily scaleable and performance can be traded-off against power consumption and die area. In addition, the digital equalizer is testable using standard ATPG (automatic test pattern generation) and circular built-in-self-test approaches.

The chosen clock recovery approach uses a Muller-Mueller approach ["Timing recovery in Digital Synchronous Data Receivers" Mueller and Muller IEEE Transactions on Communications May 1976.] where the timing function adapts the T/H sample position to the point where the calculated pre-cursor inter-symbol interference (ISI) or h(-1) is zero, an example being given in Figure 3. The two curves show the post-equalized response for 010 and 011 data sequences respectively. The intersection 30 at 3440ps occurs when the sample of the second bit is independent of the third bit - that is, h(-1) = 0. This position can be detected by comparing the post-equalized symbol amplitude with the theoretical amplitude h(0) and using the difference to update the CDR's phase-interpolator.

A block diagram of the transmitter is shown in Figure 4, which is implemented using CML techniques. The data to be transmitted (received at terminal 41) is sequentially delayed by three 1 UI delay registers 42, 43 and 44 connected in series. They produce, via the four taps before and after each delay, a nibble-wide word containing the pre-cursor, cursor and two post-cursor components. In fact to ease timing closure the data is sent to the transmitter from the digital part of the circuit that supplies the data in blocks of 4 nibbles (16 bits in parallel), the blocks being sent at a rate of 3.125/s. Each nibble is a frame of four bits of the bitstream offset by one bit from the next so the nibbles overlap and represent the data redundantly. A multiplexer then selects one of the nibbles, switching between them at a rate of 12.5 x109/s, and presents that in parallel to the four taps, thereby making the bitstream appear to advance along the taps.

A 4-tap FIR output waveform is obtained from simple current summing of the time-delayed contributions. This is done with differential amplifiers 45 to 48, each having its inputs connected to a respective one of the taps and having its differential output connected to a common differential output 49. Although shown as four differential amplifiers the circuit is implemented as one differential amplifier with four inputs, which minimizes return-loss. The relative amplitude of each contribution is weighted to allow the FIR coefficients to be optimized for a given circuit (e.g. a backplane) and minimize the overall residual ISI. The weights are determined empirically either for a typical example of a particular backplane or once a backplane is populated and are stored in registers 50 to 53. The weights respectively control the controllable driving current sources 54 to 57 of the differential amplifiers 45 to 48 to scale their output current accordingly. Respective pull-up resistors 58 and 59 are connected to the two terminals of the differential output 49.

A PLL is used to generate low-jitter reference clocks for the transmitter and receiver to meet standards["OIF-CEI-02.0 - Common Electrical I/O (CEI) - Electrical and Jitter Interoperability agreements for 6G+ bps and 11G+ bps I/O". Optical Internetworking Forum, Feb 2005; "IEEE Draft 802.3ap/Draft 3.0 - Amendment: Electrical Ethernet Operation over Electrical Backplanes" IEEE July 2006.]. Most integrated circuits will have more than one receiver 1 and the PLL is shared between them with each receiver having a phase interpolator to set the phase to that of incoming data.

The PLL uses a ring oscillator to produce four clock-phases at a quarter of the line data-rate. The lower speed clocks allow power efficient clock distribution using CMOS logic levels, but need duty-cycle and quadrature correction at the point of use. The 3.125GHz clocks are frequency doubled (XOR function) to provide the 6.25GHz clock for the T/H & ADC. The transmitter uses the four separate 3.125GHzphases, but they require accurate alignment to meet jitter specifications of 0.15UI p-p R.J. and 0.15UI p-p D.J.

The system described has been fabricated using a 65nm CMOS process and has been shown to provide error-free operation at 12.5Gb/s over short channels (two 11mm package traces, 30cmlow-loss PCB and two connectors). A legacy channel with -24dB of attenuation at 3.75 GHz supports error free operation at 7.5 Gb/s.

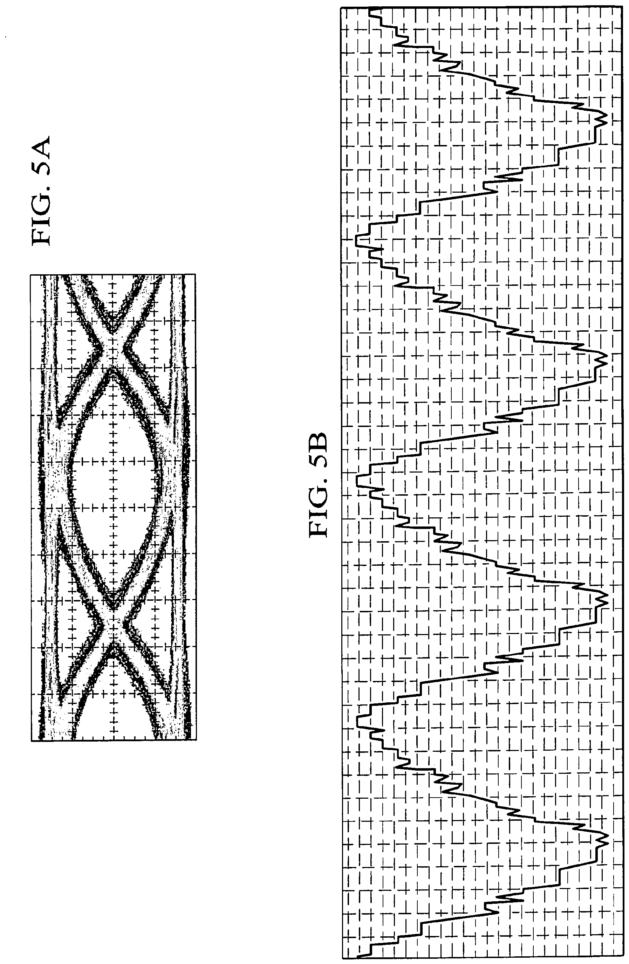

Figure 5a shows a 12.5 Gb/s 27-1 pseudo random bit stream (PRBS) transmitted eye-pattern with 20% de-emphasis on the first post-cursor. The receiver includes, for test purposes, a PRBS data verifier 66, which confirms that the test pattern has been received. The differential peak-to-peak (pp) amplitude is 700mV (200mV/div). Figure 5b shows the ADC output when a 6.25GHz sine-wave is sampled and the phase between the sine-wave and receiver is incremented using a programmable delay-line. The measured codes are within +/-1 lsb (least significant bit) of the expected values. This level of performance ensures robust operation over a wide range of cables, green-field and legacy channels. The worst-case power of a single TX/RX pair, or "lane" is 330mW and the total exemplary macro area is 0.45 mm2 per lane (allowing for the PLL being shared by four TX/RX lanes.

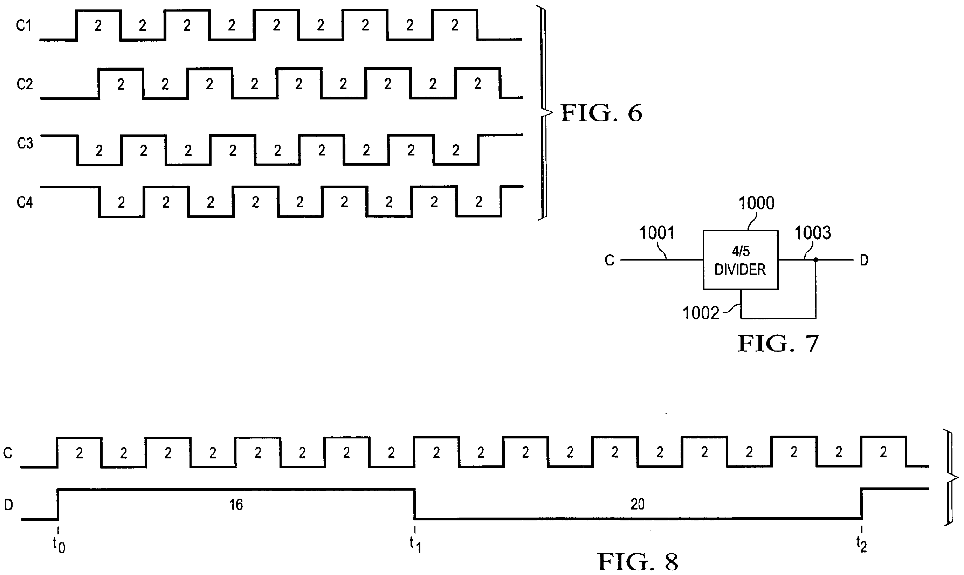

In order to generate the 33-bit clock, the invention uses four 4-bit clocks, one in each of the four possible phases. The clock signals C1 to C4 given by the four clocks are shown in Figure 6. Each clock signal alternates between two high bit periods and two low bit periods, thus giving the 4-bit clock. In the receiver 1 the four clocks are provided by the PLL 65, which in its operation selects the clock signal most in phase with the data signal on which it is locking. However, if the four clocks were not already available they could easily be generated.

A 4/5 divider 1000 is shown in Figure 7. The 4/5 divider circuit has an input 1001 for a clock signal C, a register 1002 to toggle between dividing by 4 and dividing by 5, and an output 1003 for the divided signal D. The register 1002 causes the divider 1000 to convert a 4-bit clock signal into a 16-bit high pulse when it is high (the "4" mode), and to convert a 4-bit clock signal into a 20-bit high pulse when it is low (the "5" mode). As shown in Figure 8, at time t0 the output signal D changes from low to high, switching the divider 1000 into the "4" mode. The clock signal C (a 4-bit clock signal) this makes the output D high for a period of 16 bits until time t1. The output D then changes to low, switching the divider 1000 into the "5" mode. The output D is then low for a period of 20 bits, until time t2. The output D then switches to high, and the cycle repeats. Thus the combination of the "4" mode and the "5" mode acts to divide the 4-bit clock signal by 9, giving a 36-bit clock signal.

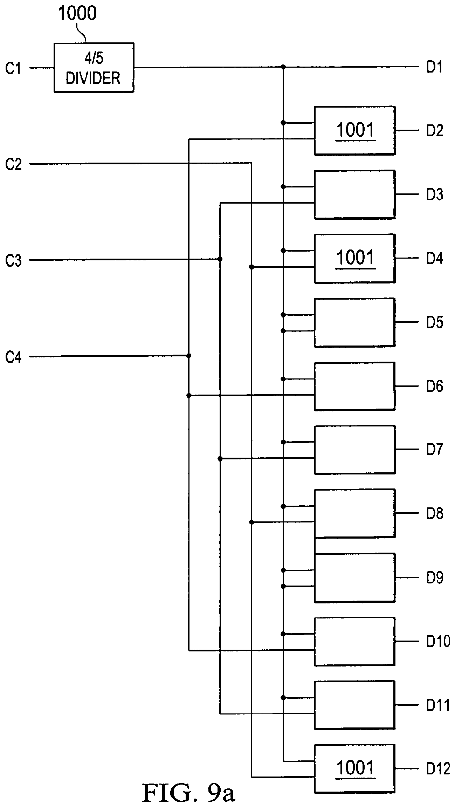

As shown in Figure 9a, the 4/5 divider 1000 is connected to a series of 11 capture circuits 1001. The capture circuits 1001 are connected to the clock signals C1 to C4 to give waveforms D1 to D12, each of which is the waveform output by the 4/5 divider 1000 delayed by a certain number of bits. The waveforms are provided as follows. Waveform D1 is simply the output of the 4/5 divider 1000 itself (no capture circuit is used). The clock signal C2 is connected to the capture circuits 1001 that provide waveforms D4, D8 and D12, which are delayed by 9 bits, 21 bits and 33 bits respectively. (The clock signal C2 is 1 bit out of phase from the clock signal C1, and 9, 21 and 33 are each a multiple of 4 plus 1, thus making the timing of the capture possible.) The clock signal C3 is connected to the capture circuits 1001 that provide waveforms D3, D7 and D11, which are delayed by 6 bits, 18 bits and 30 bits respectively. (The clock signal C3 is 2 bits out of phase from the clock signal C1, and 6, 18 and 30 are each a multiple of 4 plus 2.) Finally, the clock signal C4 is connected to the capture circuits 1001 that provide waveforms D2, D6 and D10, which are delayed by 3 bits, 15 bits and 27 bits respectively. (The clock signal C3 is 3 bits out of phase from the clock signal C1, and 3, 15 and 27 are each a multiple of 4 plus 3.)

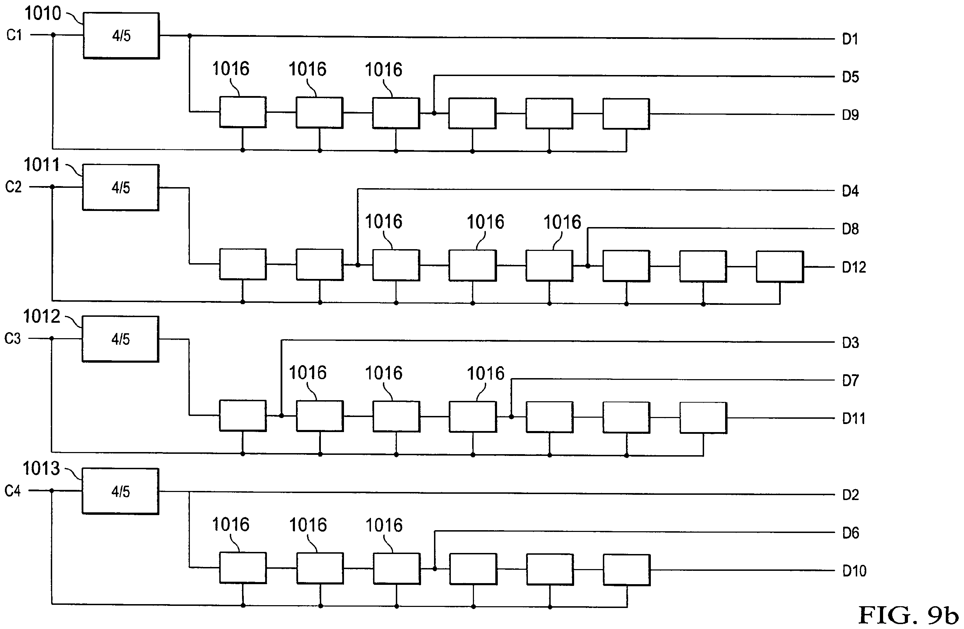

An alternative circuit for providing the waveforms is shown in Figure 9. Four 4/5 dividers 1010, 1011, 1012 and 1013 and 27 latches 1014 are used to create the twelve waveforms D1 to D12. Divider 1010 has as input clock signal C1, and its output provides the first waveform D1. The output is also used as input for a series of 6 latches, which use the clock signal C1. The output of the third latch in the series, which is the waveform D1 delayed by 12 bits, provides the waveform D5. The output of the sixth latch in the series, which is the waveform D1 delayed by 24 bits, provides the waveform D9.

Similarly, the clock signal C2 provides the input for the divider 1011, and is also used as the clock for a series of 8 latches. The output of the divider 1011 is used as input for the series of latches. The output of the second latch provides the waveform D4, the output of the fifth latch provides the waveform D8, and the output of the eight latch provides the waveform D12. Similarly again, the divider 1012 takes as input the clock signal C3, its output being used as input for a series of 7 latches; the output of the first latch provides the waveform D3, the output of the fourth latch provides the waveform D7, and the output of the seventh latch provides the waveform D11. Finally, the divider 1013 takes as input the clock signal C4, its output being used as input for a series of 6 latches, and also providing the waveform D2; the output of the third latch provides the waveform D6, and the output of the sixth latch provides the waveform D10.

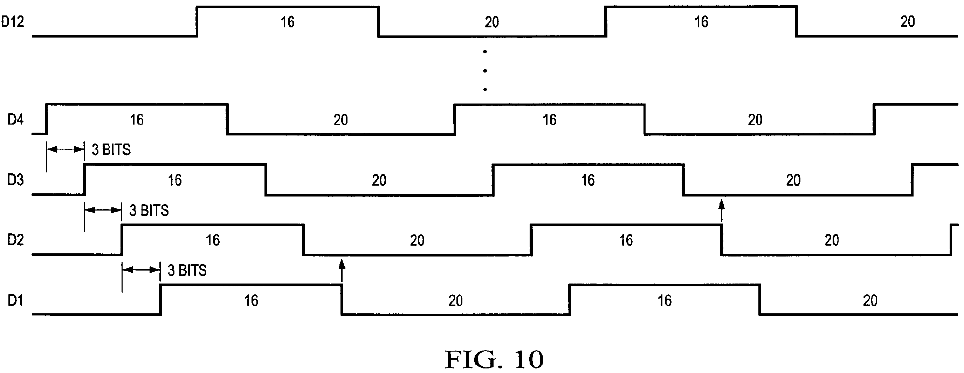

The waveforms from the dividers D1 to D12 are shown in Figure 10. As each waveform repeats after 36 (16 plus 20) bits, the first waveform D1 is also delayed three bit periods from the last waveform D12.

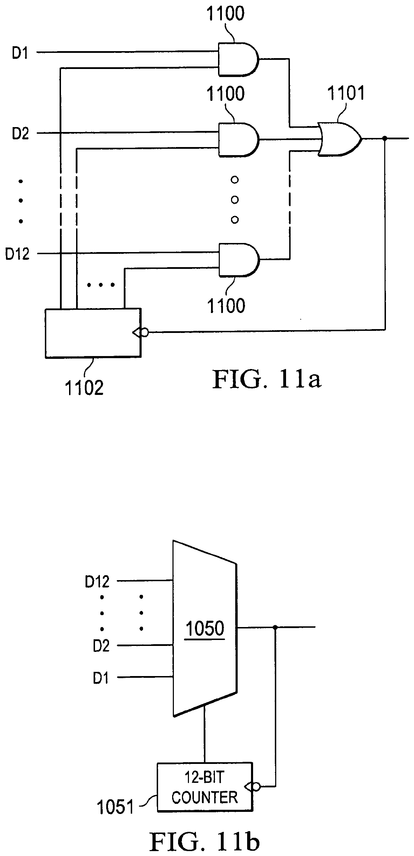

As shown in Figure 11a, each of the waveforms D1 to D12 is used as input for a respective AND gate 1100, and the output of each AND gate is used as input for an OR gate 1101. Each AND gate also has as input an output from a 12-output ring selector 1102. The ring selector has a trigger which is connected to the output of the OR gate 1101. The ring selector sends a high signal down each of its outputs in turn (while the other 11 outputs send a low signal), making the next output in turn high when the trigger receives a negative edge from the output of the OR gate 1101.

In operation, initially the first output of the ring selector 1102 is high, and the others are low, and so the output of the AND gate 1100 for D1 is the waveform D1 itself, and that for each other AND gate is simply low. The output of the OR gate 1101 is therefore the waveform D1. Once D1 changes from high to low, the ring counter 1102 makes the next output in turn high, so the AND gate for D2 outputs D2, each other AND gate is low, and so the output of the OR gate 1101 is D2. The waveform D2 is outputted for the remainder of its 20-bit low period (in other words for 17 bits, as D2 is 3 bits behind D1), and the entirety of its 16-bit high period. As in the case for D1, once D2 changes from high to low the next output of the ring selector 1102 is made high, resulting in the OR gate 1101 outputting the next waveform, in this case D3. Each signal D1 to D12 is selected in turn, in each case the next signal being selected when the current signal changes from high to low. When the final signal D12 switches from high to low, the ring selector 1102 makes the first output high again, and so the OR gate 1101 outputs the first signal D1 again.

As can be seen, the output of the OR gate 1101 will be a 16-bit high period, followed by a 17-bit low period (the final 17 bits of a 20-bit low period), and thus the output is a 33-bit clock signal as required.

An alternative circuit for selecting between the waveforms D1 to D12 is shown in Figure 11b, which uses a twelve-input multiplexer 1050. The multiplexer 1050 takes as input the waveforms D1 to D12, and the waveforms are selected by an edge-triggered 12-bit counter 1051. The edge-trigger of the counter 1051 takes as input the complement of the output of the multiplexer 1050, and so is incremented when the output of the multiplexer falls from high to low.

In operation, first the signal D1 is outputted for the entirety of its 16-bit high period. Once D1 changes from high to low, the counter 1051 is incremented, and so the multiplexer 1050 selects the next waveform D2. The waveform D2 is outputted for the remainder of its 20-bit low period (in other words for 17 bits, as D2 is 3 bits behind D1), and the entirety of its 16-bit high period. As in the case for D1, once D2 changes from high to low the counter 1051 is incremented, and so the multiplexer 1050 selects the next waveform, in this case D3. Each signal D1 to D12 is selected in turn, in each case the next signal being selected when the current signal changes from high to low. When the final signal D12 switches from high to low, the counter 1051 returns to its starting configuration, and so the multiplexer switches back to the first signal D1.

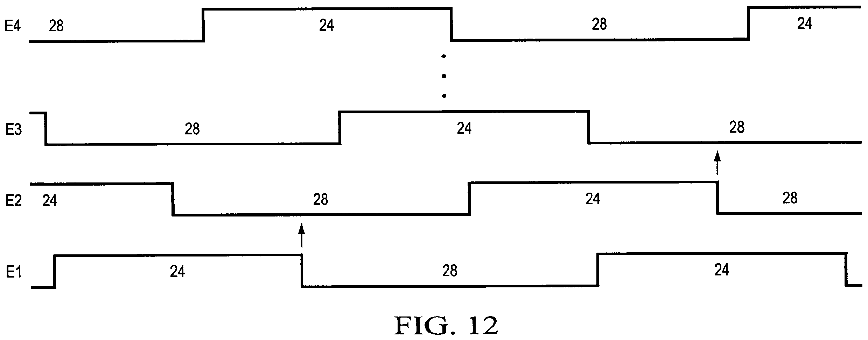

Although the example given above is for a 33-bit clock, the invention applies equally to the production clocks of a different period. An example of how to provide a 39-bit clock is shown in Figure 12. In this example, a 6/7 divider uses a 4-bit clock signal to provide a signal consisting of a 24-bit high period followed by a 28-bit low period. Four of these signals D1 to D4 are used, with a delay of 13 bits between D1 and D2, D2 and D3, and so on. These signals can be provided using dividers and delays in a similar way to the previous example. Each signal repeats every 52 bits (as 52 is 24 plus 28), and so as 13 multiplied by 4 is also 52 signal D1 is also 13 bits behind D4.

A four-input multiplexer is used to select the signals in turn, again in a similar way to the previous example. Each signal has its 24-bit high period outputted; when the signal changes from high to low, the multiplexer outputs the next signal, which will initially be low, in this case for 15 bits (28 minus 13 is 15) before entering the 24-bit high period. The multiplexer then selects the next signal again when the signal turns from high to low as before.

As can be seen, in this case the output is a 39-bit clock, consisting of a 24-bit high period followed by a 15-bit low period.

Although in the examples given above the selection of the next signal occurs when the current signal changes from high to low, it will be appreciated that it could occur at a time after the change has occurred. For example, in the generation of the 33-bit clock above the change to the next signal could occur at any time within the first 17 bits of the low period of the current signal. It will also be appreciated that the invention would work equally well if the circuits were adapted so that the selection of the next signal occurred when the current signal changed from low to high, or similarly at some point thereafter.

Although in the examples given above four 4-bit clocks have been used, the invention applies equally to situations where clocks of periods other than four bits are available. In general terms, if provided with c-bit clocks, in other words a clock with a waveform of a *c1*-bit high period followed by a *c2-*bit low period, where *c1+c2*=*c,* then using an a/b divider it is possible to make a waveform W consisting of a *c1.a* bit high period followed by a *c2.b* bit low period. (Note that it is not necessary for a and b to be different integers, nor *c1* and *c2* of course.) A number of these waveforms W, which are of length *cl.a+c2.b* bits, can be used to make a clock waveform of a shorter length *cl.a+c2.b-o* bits using a multiplexer as described above; namely, using n waveforms W1 to Wn of which each waveform is *o* bits behind the previous waveform. (This will only work if *o* is less than c2.b, the length of the low period, as we need the next waveform to still be in its low period when the current waveform switches from high to low, at which time the multiplexer switches to that next waveform.) This arrangement is particularly advantageous when *o* is a divisor of *c1.a*+*c2.b* (in other words, o.i = *cl.a+c2.b* for some integer i), as in that case only i copies of the waveform W are required. (In general the number of copies n of the waveform W needed will be the smallest integer n such that *o.n =* (*c1.a+c2.b*)*.p* for some integer *p.*)

## Claims

1. A clock circuit for dividing a clock frequency by an odd integer comprising:
a plurality of inputs for a plurality of respective clock signals (C1, C2, C3, C4), the clock signals alternating with a common frequency between a first and a second state and having phases that are evenly distributed;
at least one divider circuit (1000; 1010-1013) arranged to take an input clock signal (1001) and provide an output (1003) that is in the first state for a first fixed multiple of the duration the clock signal is in the first state, and in the second state for a second fixed multiple of the duration the clock signal is in the second state;
a plurality of delay circuits arranged to take the output of the divider circuit (1000; 1010-1013) or circuits and provide a set of outputs (D1-D12), each delayed by a fixed duration with respect to the input signals (C1-C4) and said plurality of delay circuits arranged so that the output phases thereof are equally distributed;
a selection circuit arranged to select the outputs (D1-D12) of the delay circuits in sequence;
**characterized in that** the selection circuit is arranged to select the next output (D1-D12) in the sequence at or after the time when the selected output (D1-D12) changes from the first state to the second state.

2. A clock circuit as claimed in claim 1, wherein the delay circuits are capture circuits (1001) arranged to capture the output of a divider circuit (1000) based on one of the input clock signals (C1-C4).

3. A clock circuit as claimed in claim 1, comprising a respective divider circuit (1010, 1011, 1012, 1013) for each input clock signal (C1-C4).

4. A clock circuit as claimed in claim 3, wherein the delay circuits comprise respective delays that take as input the outputs (D1-12) of the delay circuits.

5. A clock circuit as claimed in any preceding claim, wherein the selection circuit (1102) selects the next output (D1-D12) in the sequence when the selected output (D1-D12) changes from the first state to the second state,

6. A clock circuit as claimed in any preceding claim, further comprising a selection signal generating circuit (1102) arranged to generate a respective selection signal for each output (D1-D12) of a delay circuit.

7. A clock circuit as claimed in claim 6, wherein the selection circuit further comprises a respective AND gate (1100) for each output (D1-D12) of a delay circuit, and wherein the inputs of the AND gate (1100) are the output of the delay circuit (D1-D12) and its respective selection signal (1102).

8. A clock circuit as claimed in claim 7, wherein the selection circuit further comprises an OR gate (1101), and wherein the inputs of the OR gate (1101) are the outputs of the AND gates (1100).

9. A clock circuit as claimed in any of claims 1 to 5, wherein the selection circuit comprises a multiplexer (1050).

10. A clock circuit as claimed in claim 9, wherein the selection circuit further comprises a counter (1051) arranged to select the output of the multiplexer (1050).

11. A clock circuit as claimed in claim 10, wherein the counter (1051) is arranged to increment when the selected output changes from the first state (HIGH) to the second state (LOW).

12. A method of generating a clock signal by dividing a clock frequency by an odd integer from a plurality of input clock signals (C1-C4), the clock signals alternating with a common frequency between a first (HIGH) and a second (LOW) state and having phases that are evenly distributed, the method comprising the steps of:
providing at least one divided signal that is in the first state (HIGH) for a first fixed multiple of the duration the clock signal is in the first state, and in the second state for a second fixed multiple of the duration the clock signal is in the second state;
delaying the divided signal or signals to provide a set of divided signals each delayed by a fixed duration with respect to the input signals (C1-C4) and the output phases of the set of divided signals being equally distributed;
selecting a delayed signal (D1-D12) from the set of divided signals (D1-D12); and **characterized by**
at or after the time the selected delayed signal changes from the first state (HIGH) to the second state (LOW), selecting a next delayed signal (D1-D12) from the set of divided signals (D1-D12).

## Patentansprüche

1. Taktschaltung zum Teilen einer Taktfrequenz durch eine ungerade Ganzzahl, umfassend:
mehrere Eingänge für mehrere jeweilige Taktsignale (C1, C2, C3, C4), wobei die Taktsignale mit einer gemeinsamen Frequenz zwischen einem ersten und einem zweiten Zustand hin und her wechseln und Phasen haben, die gleichmäßig verteilt sind;
zumindest eine Teilerschaltung (1000; 1010-1013), die angeordnet ist, ein Eingangstaktsignal (1001) aufzunehmen und einen Ausgang (1003) bereitzustellen, der für ein erstes fixiertes Vielfaches der Dauer, die das Taktsignal im ersten Zustand ist, im ersten Zustand ist und für ein zweites fixiertes Vielfaches der Dauer, die das Taktsignal im zweiten Zustand ist, im zweiten Zustand ist;
mehrere Verzögerungsschaltungen, die angeordnet sind, den Ausgang der Teilerschaltung (1000; 1010-1013) oder - schaltungen aufzunehmen und einen Satz von Ausgängen (D1-D12) bereitzustellen, wobei jeder durch eine fixierte Dauer in Bezug auf die Eingangssignale (C1-C4) verzögert ist, und die mehreren Verzögerungsschaltungen angeordnet sind, sodass ihre Ausgangsphasen gleich verteilt sind;
eine Auswahlschaltung, die angeordnet ist, die Ausgänge (D1-D12) der Verzögerungsschaltungen in Folge auszuwählen;
**dadurch gekennzeichnet, dass** die Auswahlschaltung angeordnet ist, den nächsten Ausgang (D1-D12) in der Folge bei oder nach dem Zeitpunkt, wenn der ausgewählte Ausgang (D1-D12) sich vom ersten Zustand zum zweiten Zustand ändert, auszuwählen.

2. Taktschaltung nach Anspruch 1, wobei die Verzögerungsschaltungen Aufnahmeschaltungen (1001) sind, die angeordnet sind, den Ausgang einer Teilerschaltung (1000) basierend auf einem der Eingangstaktsignale (C1-C4) aufzunehmen.

3. Taktschaltung nach Anspruch 1, umfassend eine jeweilige Teilerschaltung (1010, 1011, 1012, 1013) für jedes Eingangstaktsignal (C1-C4).

4. Taktschaltung nach Anspruch 3, wobei die Verzögerungsschaltungen jeweilige Verzögerungen umfassen, die als Eingang die Ausgänge (D1-12) der Verzögerungsschaltungen aufnehmen.

5. Taktschaltung nach einem der vorangehenden Ansprüche, wobei die Auswahlschaltung (1102) den nächsten Ausgang (D1-D12) in der Folge auswählt, wenn sich der ausgewählte Ausgang (D1-D12) vom ersten Zustand zum zweiten Zustand ändert.

6. Taktschaltung nach einem der vorangehenden Ansprüche, ferner umfassend eine Auswahlsignalerzeugungsschaltung (1102), die angeordnet ist, ein jeweiliges Auswahlsignal für jeden Ausgang (D1-D12) einer Verzögerungsschaltung zu erzeugen.

7. Taktschaltung nach Anspruch 6, wobei die Auswahlschaltung ferner ein jeweiliges UND-Gate (1100) für jeden Ausgang (D1-D12) einer Verzögerungsschaltung umfasst, und wobei die Eingänge des UND-Gates (1100) der Ausgang der Verzögerungsschaltung (D1-D12) und dessen jeweiliges Auswahlsignal (1102) sind.

8. Taktschaltung nach Anspruch 7, wobei die Auswahlschaltung ferner ein ODER-Gate (1101) umfasst, und wobei die Eingänge des ODER-Gates (1101) die Ausgänge der UND-Gates (1100) sind.

9. Taktschaltung nach einem der Ansprüche 1 bis 5, wobei die Auswahlschaltung einen Multiplexer (1050) umfasst.

10. Taktschaltung nach Anspruch 9, wobei die Auswahlschaltung ferner einen Zähler (1051) umfasst, der angeordnet ist, den Ausgang des Multiplexers (1050) auszuwählen.

11. Taktschaltung nach Anspruch 10, wobei der Zähler (1051) angeordnet ist hochzuzählen, wenn sich der ausgewählte Ausgang vom ersten Zustand (HIGH) zum zweiten Zustand (LOW) ändert.

12. Verfahren zur Erzeugung eines Taktsignals durch Teilen einer Taktfrequenz durch eine ungerade Ganzzahl von mehreren Eingangstaktsignalen (C1-C4), wobei die Taktsignale mit einer gemeinsamen Frequenz zwischen einem ersten (HIGH) und einem zweiten (LOW) Zustand wechseln und Phasen haben, die gleichmäßig verteilt sind, das Verfahren umfassend die Schritte zum:
Bereitstellen zumindest eines geteilten Signals, das für ein erstes fixiertes Vielfaches der Dauer, die das Taktsignal im ersten Zustand ist, im ersten Zustand (HIGH) ist, und für ein zweites fixiertes Vielfaches der Dauer, die das Taktsignal im zweiten Zustand ist, im zweiten Zustand ist;
Verzögern des geteilten Signals oder der geteilten Signale, um einen Satz an geteilten Signalen bereitzustellen, wobei jedes um eine fixierte Dauer in Bezug auf die Eingangssignale (C1-C4) verzögert ist und die Ausgangsphasen des Satzes von geteilten Signalen gleichmäßig verteilt ist;
Auswählen eines verzögerten Signals (D1-D12) aus dem Satz von geteilten Signalen (D1-D12); und **gekennzeichnet durch**
bei oder nach dem Zeitpunkt, zu dem sich das ausgewählte verzögerte Signal vom ersten Zustand (HIGH) zum zweiten Zustand (LOW) ändert, Auswählen eines nächsten verzögerten Signals (D1-D12) aus dem Satz von geteilten Signalen (D1-D12).

## Revendications

1. Circuit d'horloge pour diviser une fréquence d'horloge par un nombre entier impair, comprenant :
une pluralité d'entrées pour une pluralité de signaux d'horloge respectifs (C1, C2, C3, C4), ces signaux d'horloge alternant avec une fréquence commune entre un premier et un deuxième état et ayant des phases qui sont réparties de manière uniforme ;
au moins un circuit diviseur (1000 ; 1010-1013) agencé de façon à prendre un signal d'horloge d'entrée (1001) et à fournir une sortie (1003) qui est dans le premier état pendant un premier multiple fixe de la durée pendant laquelle le signal d'horloge est dans le premier état, et dans le deuxième état pendant un deuxième multiple fixe de la durée pendant laquelle le signal d'horloge est dans le deuxième état ;
une pluralité de circuits à retard agencés de façon à prendre la sortie du ou des circuits diviseurs (1000 ; 1010-1013) et à fournir un ensemble de sorties (D1-D12), chacun étant retardé d'une durée fixe par rapport aux signaux d'entrée (C1-C4) et ladite pluralité de circuits à retard étant agencés de manière à ce que les phases de sortie de ceux-ci soient réparties de manière égale ;
un circuit de sélection agencé de façon à sélectionner les sorties (D1-D12) des circuits à retard en séquence ;
**caractérisé en ce que** le circuit de sélection est agencé de façon à sélectionner la sortie suivante (D1-D12) dans la séquence au moment où ou après le moment où la sortie sélectionnée (D1-D12) change du premier état au deuxième état.

2. Circuit d'horloge selon la revendication 1, dans lequel les circuits à retard sont des circuits de capture (1001) agencés de façon à capturer la sortie d'un circuit diviseur (1000) en se basant sur un des signaux d'horloge d'entrée (C1-C4).

3. Circuit d'horloge selon la revendication 1, comprenant un circuit diviseur respectif (1010, 1011, 1012, 1013) pour chaque signal d'horloge d'entrée (C1-C4).

4. Circuit d'horloge selon la revendication 3, dans lequel les circuits à retard comportent des retards respectifs qui prennent comme entrée les sorties (D1-12) des circuits à retard.

5. Circuit d'horloge selon l'une quelconque des revendications précédentes, dans lequel le circuit de sélection (1102) sélectionne la sortie suivante (D1-D12) dans la séquence lorsque la sortie sélectionnée (D1-D12) change du premier état au deuxième état.

6. Circuit d'horloge selon l'une quelconque des revendications précédentes, comprenant en outre un circuit de génération de signal de sélection (1102) agencé de façon à générer un signal de sélection respectif pour chaque sortie (D1-D12) d'un circuit à retard.

7. Circuit d'horloge selon la revendication 6, dans lequel le circuit de sélection comprend en outre une porte ET respective (1100) pour chaque sortie (D1-D12) d'un circuit à retard, et dans lequel les entrées de cette porte ET (1100) sont la sortie du circuit à retard (D1-D12) et son signal de sélection respectif (1102).

8. Circuit d'horloge selon la revendication 7, dans lequel le circuit de sélection comprend en outre une porte OU (1101), et dans lequel les entrées de cette porte OU (1101) sont les sorties des portes ET (1100).

9. Circuit d'horloge selon l'une quelconque des revendications 1 à 5, dans lequel le circuit de sélection comprend un multiplexeur (1050).

10. Circuit d'horloge selon la revendication 9, dans lequel le circuit de sélection comprend en outre un compteur (1051) agencé de façon à sélectionner la sortie du multiplexeur (1050).

11. Circuit d'horloge selon la revendication 10, dans lequel le compteur (1051) est agencé de façon à augmenter son compte quand la sortie sélectionnée change du premier état (ÉLEVÉ) au deuxième état (BAS).

12. Procédé de génération d'un signal d'horloge en divisant une fréquence d'horloge par un nombre entier impair à partir d'une pluralité de signaux d'horloge d'entrée (C1-C4), ces signaux d'horloge alternant avec une fréquence commune entre un premier état (ÉLEVÉ) et un deuxième état (BAS) et ayant des phases qui sont réparties de façon à uniforme, ce procédé comprenant les étapes consistant à :
fournir au moins un signal divisé qui est dans le premier état (ÉLEVÉ) pendant un premier multiple fixe de la durée pendant laquelle le signal d'horloge est dans le premier état, et dans le deuxième état pendant un deuxième multiple fixe de la durée pendant laquelle le signal d'horloge est dans le deuxième état ;
retarder le signal divisé ou les signaux divisés de façon à fournir un ensemble de signaux divisés retardés chacun d'une durée fixe par rapport aux signaux d'entrée (C1-C4) et les phases de sortie de chaque ensemble de signaux divisés étant réparties de manière égale ;
sélectionner un signal retardé (D1-D12) parmi l'ensemble de signaux divisés (D1-D12) ; et **caractérisé par**, au moment où après le moment où le signal retardé sélectionné change du premier état (ÉLEVÉ) au deuxième état (BAS), la sélection d'un signal retardé suivant (D1-D12) parmi l'ensemble de signaux divisés (D1-D12).
